Europäisches Patentamt

European Patent Office

Office européen des brevets

(11) Publication number: **0 452 493 A1**

(12) **EUROPEAN PATENT APPLICATION**
**published in accordance with Art.**
**158(3) EPC**

(21) Application number: 90900358.4

(22) Date of filing: 26.12.89

(86) International application number:
PCT/JP89/01308

(87) International publication number:
WO 90/07587 (12.07.90 90/16)

(51) Int. Cl.5: **C23C 16/44**, C23C 14/22,
C23F 4/00, H01L 21/302,
H01L 21/205, H01L 21/31

(30) Priority: 29.12.88 JP 335354/88

(43) Date of publication of application:
23.10.91 Bulletin 91/43

(84) Designated Contracting States:
AT BE DE FR GB IT LU NL SE

(71) Applicant: OHMI, Tadahiro
1-17-301, Komegabukuro 2-chome Aoba-ku
Sendai-shi Miyagi-ken 980(JP)

(72) Inventor: OHMI, Tadahiro 1-17-301,
Komegabukuro 2-chome
Aoba-ku Sendai-shi

Miyagi-ken 980(JP)
Inventor: NAKAHARA, Fumio
Sanken-haitsu-koiwa 101
3-3, Kitakoiwa 4-chome Edogawa-ku
Tokyo 133(JP)
Inventor: SUGIYAMA, Kazuhiko
Sanraifu-nagamachi 303
21-6, Nagamachi 8-chome Taihaku-ku
Sendai-shi
Miyagi-ken 980(JP)

(74) Representative: Weitzel, Wolfgang, Dr.-Ing.
Friedenstrasse 10
W-7920 Heidenheim(DE)

(54) FEEDER FOR PROCESS GAS.

(57) In a feeder for feeding process gas into a processing device, gas-contacting portions of all component parts of the gas feeder are made of material not containing organic substances so that contamination in the gas feeding pipe line otherwise caused by gas emitted from organic substances may be prevented.

## Field of the Technology

This invention relates to a process gas feeder suited to, for instance, formation of a various types of thin film or a fine pattern dry etching process, and particularly to a process gas feeder which allows formation of high quality films and high quality etching.

## (Background of the Technology)

In recent years, the technology for ultra-high purification of process atmosphere , or in other words the technology for feeding ultra-high purity process gas to processing equipment in such processes as formation of a high quality thin film or fine pattern dry etching has been becoming increasingly important.

For instance, in the field of semiconductor devices, dimensions of unit chips have been becoming increasingly smaller year by year to raise integrity of integrated circuits, and research and development efforts to put into practical use semiconductor devices with a dimension of 1 $\mu$ m to sub-micron, or even 0.5 $\mu$ m or below are very active. This type of semiconductor devices are produced by repeating such processes as forming a thin film or etching a specified circuit pattern. And, generally this type of process is performed by putting a silicon wafer in a reaction chamber into which a specified gas is introduced under depressurised atmosphere. Depressurization is made to etch a through-hole or a contact hole with an aspect ratio, to make longer an average free travel of gas molecules, and to promote surface reaction and suppress gaseous reaction.

If any impurity mixes in the reactive atmosphere in this type of process, such problems as degradation of a thin film, low precision in fine processing, and low adhesion between films occur. To produce integrated circuits having sub-micron or lower sub-micron patterns on a large diameter wafer, it is necessary to completely control reactive atmosphere committing in film forming or etching. This is the reason why the technology to supply ultra-high purity gas is important.

Gases used in a semiconductor manufacturing system include general gases ($N_2$,Ar,He,$O_2$,$H_2$) which are relatively stable, and specific material gases ($AsH_3$,$PH_3$, $SiH_4$,$Si_2H_6$,HCl,$NH_3$,$Cl_2$,$CF_4$,$SF_8$,$NF_3$,$WH_6$, etc.) which have such characteristics as high toxicity, self-combustibility, and corrosiveness.

In most cases general gasses is compressed and directly sent from a refining system to a semiconductor manufacturing system as their handling is relatively easy, and with development or improvement of storage tanks, refining systems, and piping, it has become possible to supply a high purity gas. ( Tadahiro Ohmi, "Challenge to ppt -Gas Piping System for Semiconductors Challenging to Impurities at the Order of ppt", Nikkei Micro Device, July, 1987,pp.98-119)

On the other hand, careful attention is required in handling specific material gasses, and their use rate is smaller than that of general gasses, so that in most cases a gas is put in a cylinder and is sent via a cylinder-cabinet piping system to a semiconductor manufacturing system.

So far, in high purification of a gas supplied via a cylinder-cabinet piping system from a cylinder, the most serious problems are dirtiness of an inner surface of a cylinder itself, existence of heavy gas leakage to outside at a connecting section between a cylinder valve and the cylinder, and contamination by a large volume of absorbed gas generated because inside of a cylinder valve can not be cleaned.

These problems have been almost overcome, however, by finishing an inner surface of a cylinder to a mirror surface not having any layer that deteriorates during manufacturing by means of composite electrolytic polishing, or by introduction of a cylinder valve based on an external screw system incorporating a purge valve and using MCG (Metal C Ring fitting) (Tadahiro Ohmi, Jun'ichi Murota, "Clean Bomb and Gas Filling Technique", Collection of draft papers for the 6th Ultra Clean Technology Symposium "High Performance Process Technology III", January 1988, pp.109-128.)

Furthermore, a system, wherein the entire piping line for the cylinder-cabinet piping system is based on a double construction to store a gas cylinder and supply a process gas, the purge gas supply line can always be purged, and contamination by invasion of air into the piping system or release of gasses containing moisture from the inner surface of the piping material, has been developed, so that now it is possible to supply a ultra-high purity gas.

Furthermore, a gas feed piping system, wherein each of the gas feed pipes to a plurality of processing systems can be purged independently respectively, a gas flow can always be maintained in the piping system, and influence of gasses released from the inner surface of the piping material is minimized, has been realized, so that now it is possible to feed a gas from a refining system or a cylinder-cabinet to a processing system keeping its ultra-high purity. (Fumio Nakahara, Kazuhiko Sugiyama, Tsuyoshi Satoh, Tadahiro Ohmi, "Theory for Designing a Process

Gas Piping System", Collection of papers for the 7th Super LSI Ultra Clean Technology Symposium "Sub-micron ULSI Process Technology", July, 1988,pp.51-77).

(Prior Art)

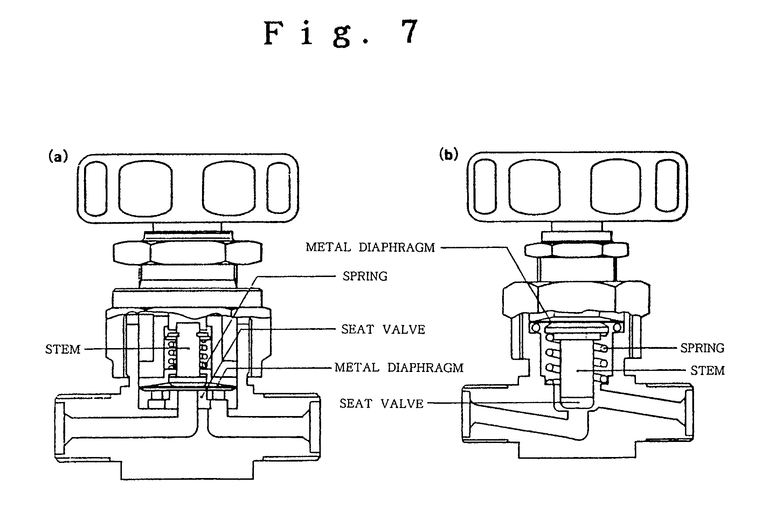

As for components of the above-described piping system wherein influence of released gasses is minimized, for instance, a valve as described in Fig.7 (b) is used. In this valve, organic material such as resin is used for the valve seat (seat section) to improve its sealing capability.

Even in the above-described piping system wherein influence of released gas is minimized, however, moisture is included in a gas at an order of around 200 ppb, and when a gas containing moisture at this order is sent to a processing system, the following problems occur.

1) For instance, in the newly developed RF-DC coupled mode bias spattering system, it is possible to produce an extremely excellent Al thin film having a mirror-like surface where any hillock does not appear even when processed under the temperature of 400°C. (T. Ohmi, H. Kuwabara, T. Shibata and T. Kiyota, "RF-DC coupled mode bias sputtering for ULSI metalization", S. Broydo and C. M. Osburn, Ed., "ULSI Science and Technology/1987", The Electrochemical Society Inc. , Philadelphia. Proc. Vol. 87-11, pp. 574-592, and T. Ohimi, "Through-removal of impurities, Understanding of conditions for producing an Al film on which any hillock does not appear", Nikkei Micro Device, October 1987,pp.109-111). In production of an Al film using this system, it is generally known that the optical condition for producing an Al film can be obtained only when a moisture content in Ar is suppressed to 10 ppb or below. If a moisture content in Ar spattering atmosphere is 10 ppb or more, morphology of the Al film surface deteriorates, which makes it impossible to optimize parameters for production of Al films with a resistivity equal to that of bulk Al on which any hillock does not appear.

2) Furthermore, this film production technology can be applied to production of Si films, and Si epitaxial growth under a low temperature of 350°C has been realized, and in this Si epitaxial growth, it is possible to dope impurities simultaneously. In this Si film production, it is generally known that cleaning the process atmosphere such as removing contamination by molecules adhered to the surface is a prerequisite for production of high quality films. For instance, even if other conditions for producing a film are identical, when the process atmosphere has been contaminated by gasses released from the inner surface of the chamber, only amorphous films can be obtained (T. Ohmi, T. Ichikawa, T. Shibata, K. Matsudo, and H. Iwabuchi, "Insitu Substrate-Surface Cleaning for Very Low Temperature Silicon Epitaxy by Low Kinetic Energy Particle Bombardment",Appl.Phys.Lett.53,4 July (1988)) and (T. Ohmi, T. Ichikawa, T. Shibata, K. Matsudo and H. Iwabuchi, "Low-Temperature Silicon Epitaxy by Low-Energy Bias Sputtering", Appl.Phys.Lett.1 August (1988)).

3) It was found that, in production of Si films using such a ultra-high purity gas as $SiH_4, H_2$, or $N_2$ with a moisture content of 10 ppb or below in a depressurized CVD, if moisture absorption on a wafer surface is suppressed to a fully low level, selective growth and epitaxial growth are realized under the practical conditions for producing thin films (Temperature: 650°C, Pressure: Several Torrs), under which it had been regarded that selective growth and epitaxial growth were impossible. In other words, Si epitaxial growth can be realized on a clean surface of Si wafer, and formation of poli-silicon films consisting of $SiO_2$ can be suppressed to the minimum level (J. Murota, N. Nakamura, M. Katoh, N. Mikoshiba, and T. Ohmi, "Ultra-Clean CVD Technology Having High Selectivity", Collection of papers for the 6th Ultra LSI Ultra-Clean Technology Symposium "For High Performance Process Technology", January 1988, pp. 215 - 226). Yet, if a process gas containing moisture at an order of 10 ppb or more, it is difficult to produce such a film.

This invention was made to solve the problems as described above, and the purpose is to provide a gas feeder which does not release gasses giving bad effects to processes, in which moisture or any organic material commits, in a gas feeding system from a cylinder cabinet to a processing system almost at all.

Disclosure of the invention

Essence of this invention consists in a process gas feeder characterized in that gas contacting sections of all gas feeding components constituting the aforesaid gas feeder are made of materials not containing any organic material to prevent contamination of inside of the gas feed piping system by gasses released from any organic material.

Herein, the gas feed components include, for instance, a cylinder, a piping, a valve, a regulator, and a filter.

Other materials than organic ones include metallic and ceramic ones.

As metallic or ceramic materials, for instance, stainless steel or that with a passive state film on its surface is preferred.

Furthermore, as a passive state film, 1) a passive film comprising 2 or more layers including a layer formed close to an interface between the stainless steel layer and the passive state film and made of mainly chrome oxide and a layer formed close to a surface of the passive state film and made of mainly iron oxide, 2) a passive state film consisting of a layer made of mainly mixture of chrome oxide and iron oxide, and 3) a passive state film consisting of a layer made of mainly chrome oxide are preferred. Especially, a passive state film with a thickness of 100Å or more formed by heating and oxidizing stainless steel under a temperature in a range from 400 °C to 550 °C in case of 1), a passive state film with a thickness of 100Å or more formed by heating and oxidizing stainless steel for less than 9 hours under a temperature of 550°C or more in case of 2), and a passive state film with a thickness of 130Å or more formed by heating and oxidizing stainless steel for 9 hours or more under a temperature of 550 °C or more are preferred because of their excellent corrosion resistance and their capability to prevent release of moisture ( the moisture release rate in these passive state films is one tenth or below of that in a passive state film formed using nitric acid). Note that it is preferred to form these passive state films in oxygen atmosphere with a moisture content of 10 ppb or below (more preferably 1 ppb or below).

Furthermore, it is preferable for improving the corrosion resistance, prevention of moisture release, and prevention of leakage that, in a surface of stainless steel on which a passive state film is formed, the maximum value in difference of height between a convex section and a concave section within a circle having a radius of 5 $\mu$ m is 1 $\mu$ m or below (preferably 0.1 to 1 $\mu$ m) (mirror-like finishing). In this case, the leak rate can be suppressed to a level of $1 \times 10^{-11}$ Torr·1/sec or below. Note that manufacturing to obtain the surface flatness as described above can be performed, for instance, by means of electrolytic polishing.

A gas feed piping system according to this invention is characterized in that organic materials such as resin are eliminated from all gas-contacting sections of all piping components including valves, regulators, and filters and all of them are made of metallic or ceramic materials. Furthermore, the gas feed piping system is characterized in that influence by gasses released from organic materials used in the aforesaid gas-contacting sections are completely eliminated and bad effects such as corrosion due to moisture contained in the organic materials are removed.

Effects

Description is made below for effects of this invention with reference to knowledge obtained in efforts for this invention.

This inventor made serious efforts to search for reasons why moisture is contained in a process gas even in a piping system in which influence by gasses is suppressed to the minimum level.

As a result, this inventor found out that the reason why moisture is contained in a process gas consists in a fact that, in process gas feeders based on the conventional technology, gas-contacting sections of the piping components such as a seat section of a valve, a conductance control section for pressure control in a regulator, and a packing for a filter are made of organic materials. In other words, gas-contacting sections inside piping components such as a valve seat section, a conductance control section for controlling pressure in a regulator, or a filter packing, many organic materials such as resin have been used. These types of resin are made of organic materials, absorb moisture, and contain unconverted organic materials, so that, when a gas is flown in an piping component using resin in the gas-contacting section therein, moisture or organic materials contained in the resin are released and a process gas to be fed to a processing system is contaminated.

For instance, in the field of valves, even in a metal diaphragm valve which has been evaluated excellent in feeding a high purity gas, organic materials such as resin are used in the seat section thereof, so that emission of gasses from the resin centering on moisture can not be suppressed completely.

If a gas flowing in a gas feed piping system is contaminated by moisture or any organic material, severe influence is effected to the manufacturing process as described above.

For these reasons, this inventor made various types of experiments as described below to suppress release of moisture from an organic material.

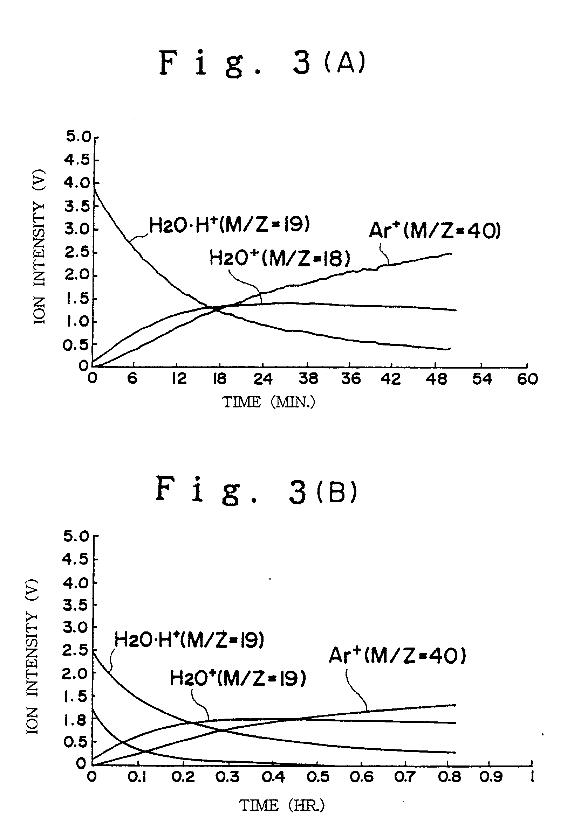

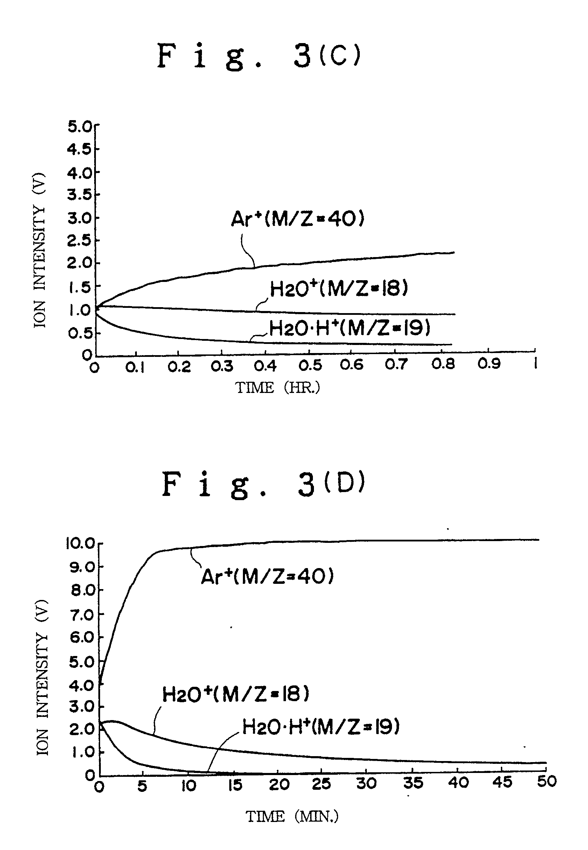

Fig. 3 shows change of moisture content in a purge gas when a metallic diaphragm valve having a seat section made of different materials is purged under the room temperature. In this experiment, Ar gas was fed to a metal diaphragm valve at a flow rate of 1.2 l/min, and moisture content in the Ar gas at the exist was measured by an APIMS (Atmospheric pressure ionization mass spectrometer). Also Fig. 3 shows a result of measurement by the APIMS in the MID mode (method for measuring behaviors of several types of ion simultaneously), and in this figure ion intensity of M/Z = 18 ($H_2O^+$), 19 ($H_3O^+$) increases in association with increase of moisture content, while ion intensity of Argon (M/Z = 40; $Ar^+$) which is a host gas decreases. The percentage of increase or decrease of ion intensity completely depends on the moisture content. In either case, measurement was started in 2 minutes after the sample was placed.

Types of the tested metal diaphragm valve are as shown below.

A: A valve based a construction shown in Fig.7 (b) and having a seat section made of polyimide resin

B: A valve based on a construction shown in Fig.7 (a) and having a seat section made of polyimide

C: A valve based on a construction shown in Fig.7 (a) and having a seat section made of polyimide resin coated with metallic material by means of sputtering.

D: A valve based on a construction shown in Fig.7(a) and having a seat section finished to a mirror-like state and coated with a passive state film

Note that, in the construction shown in Fig.7 (a), the springs and stem are put outside of an area where a gas flows and a gas retention section has been eliminated by employing an improved gas flow path. An unobstructed capacity of this valve is 1/2 of that of the valve shown in Fig. 7 (b).

Fig. 3 consists of graphs A,B,C, and D. Each metal diaphragm valve was left for about 1 week in a clean room under a relative humidity of 50% and a temperature of $20\,^{\circ}C$, and then this experiment was made.

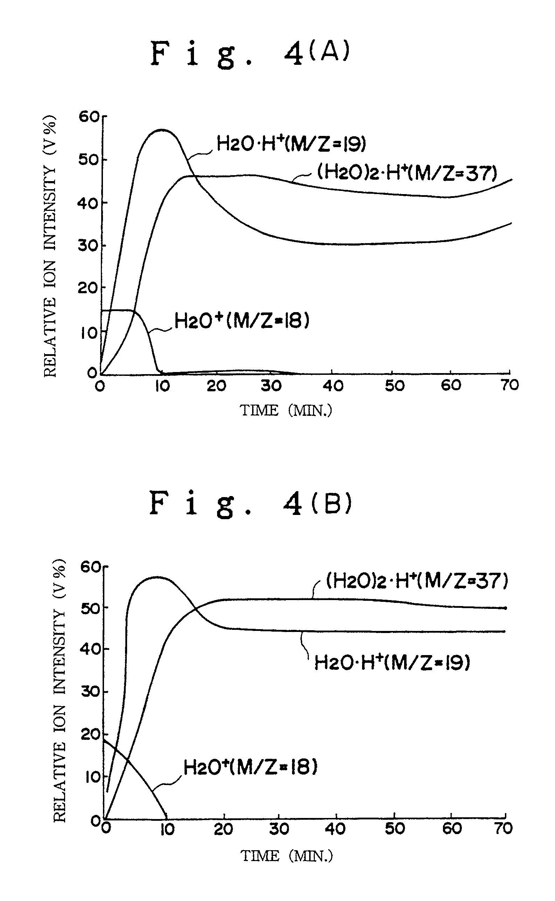

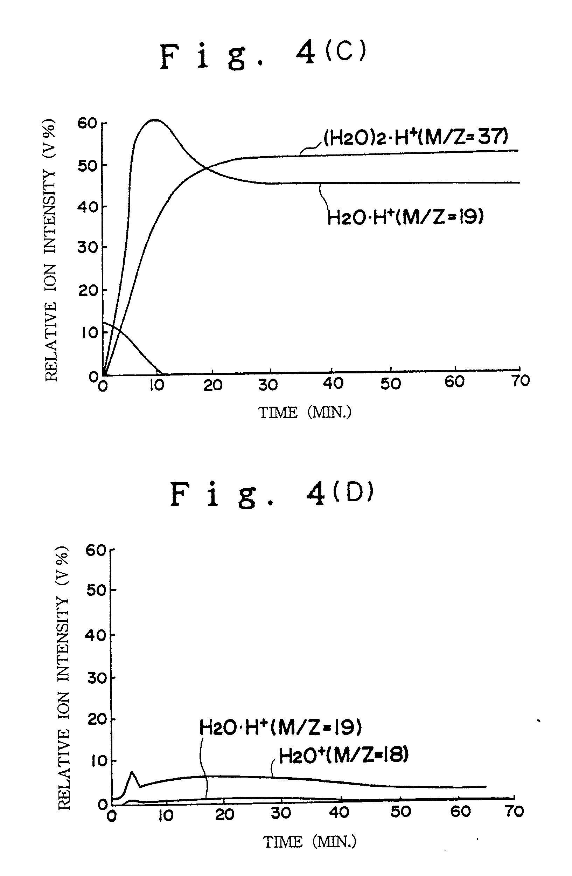

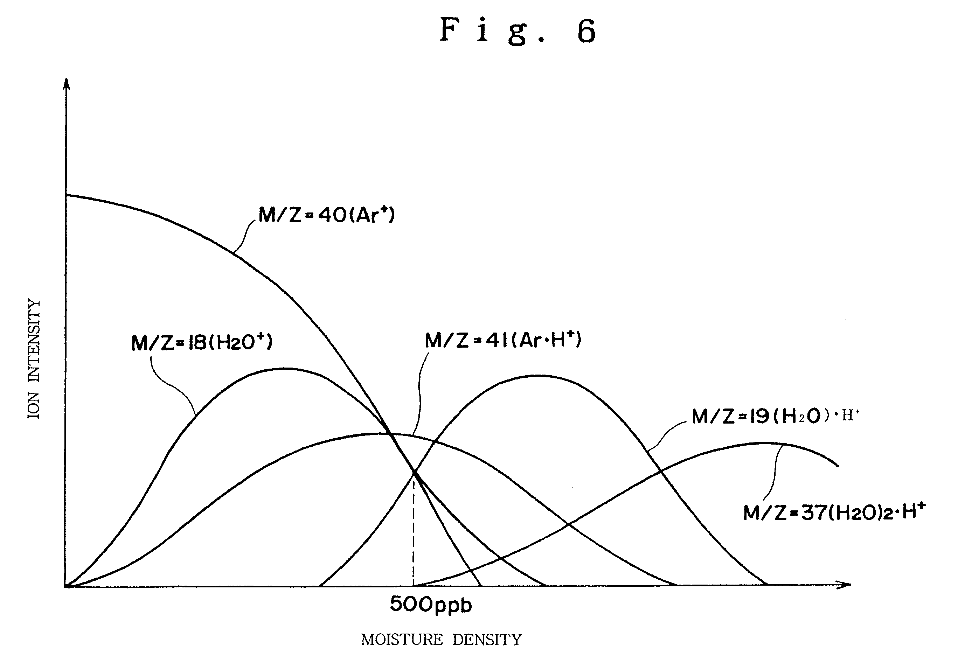

As shown in Fig. 3 A,B and C, in any of the valve A the valve B with a minimized dead space, and the valve C with the resin section coated with metal, a large volume of moisture was detected. Even after the gas was fed for about 1 hour, moisture was detected at an order of about 200 ppb in A and B, and at an order of 150 ppb in C, which indicates that reduction of moisture is very hard. In contract, in the valve D wherein resin was eliminated from the gas-contacting section, the moisture contents dropped to 16 ppb after the gas was fed for 1 hour. Thus, the valve D is more excellent in its capability to remove moisture by one order or more than the valves A,B and C, and has extremely excellent absorbed gas degassing characteristics. Fig. 4 shows change in moisture content when these valves were heated to 130 $^{\circ}C$ by a heater with relative ion intensity, and A,B,C and D correspond to those in Fig.3 respectively. Fig. 6 is also a simple graph illustrating behaviors f moisture in the APIMS. In an APIMS, when a moisture content goes up in the system, ion intensity of a host gas (In this case: Argon) drops, while the number of water ions $H_2O^+$ (M/Z = 18) increases. Furthermore, when the moisture content start increasing, water ions $H_2O^+$ (M/Z = 18) start decreasing, while water cluster ions $H_2O \cdot H^+$ ( M/Z = 19) start increasing. If moisture increases furthermore, water cluster ions $H_2O \cdot H^+$ (M/Z = 19) decreases, while water dimer cluster ions $(H_2O)_2 \cdot H^+$ (M/Z = 37) increases.

As clearly shown in Fig.4, A,B and C, a large quantity of moisture was detected in any of the valve A, the valve B with a minimized dead space, and the valve C with the resin section coated with metallic material. In these valves, moisture was released at an order of several thousands ppb in about 15 minutes after heating was started, and this state was kept after heating was continued for 1 hours. In other words, release of moisture was continued everlastingly. In contrast, in the valve D, the moisture release rate after heating was started was 100 ppb or less, indicating that the moisture release rate was largely ( by max. 2 digits) smaller than those in other valves.

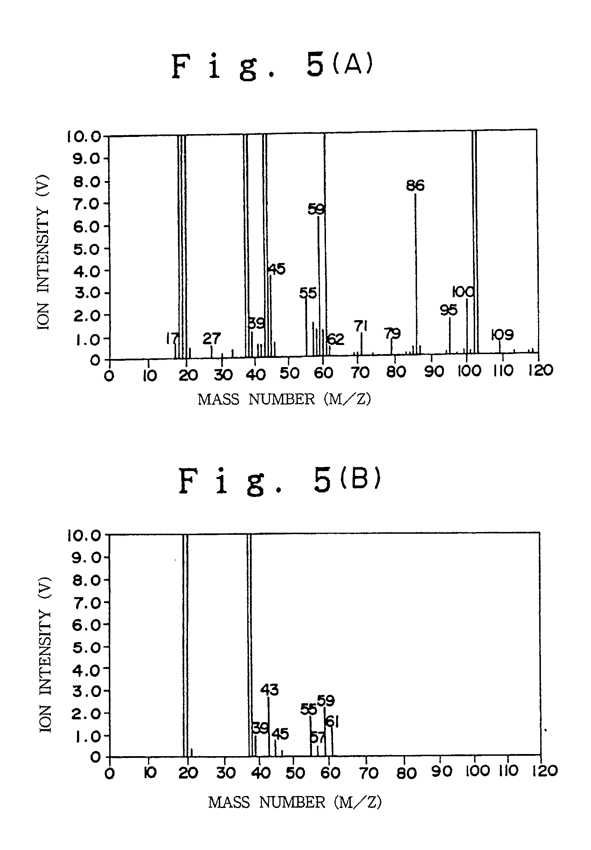

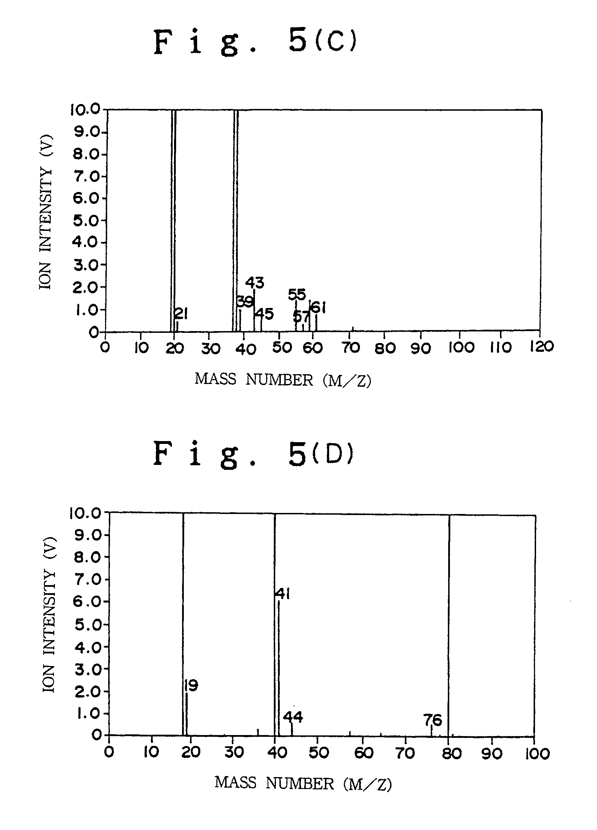

Fig. 5 shows representative spectrums during heating, and A,B, C and D correspond to those in Fig. 4 respectively. In Fig. 5 A,B and C, not only a peak of the host gas (Argon) disappeared due to influence by a quantity of released moisture, but also materials with the mass number (M/Z) of 43,45,59,61 and 71, which could be regarded as organic materials, were detected. In contract, in D, a peak of the host gas (Argon) (M/Z = 40,80) was detected, and in addition to moisture, only a small quantity of air components ( such as $CO_2$ with the M/Z of 44) were detected. Thus, in the valve D not using any organic material in the gas-contacting section, not only the moisture release rate was low, but also release of organic materials giving bad effects to the semiconductor manufacturing process was not observed.

In the field of filters, a ceramic filter using ceramics, which is in-organic material, in its elements has been developed, and a nickel packing is available for the gasket, so that resin, an organic material conventionally used, can be removed from its gas-contacting section. Furthermore, the elements can be made of stainless and their connection to the housing may be made by means of welding, so that an all-metal filter completely made of stainless steel is available.

Thus, release of gas from seat sections or other gas-contacting sections can be suppressed by eliminating all organic materials from gas-contacting sections in a gas feed system and using metal or ceramics in place of the organic materials in the sections. Also, by using a metallic material, especially stainless steel, gas-contacting sections can be passivated to a metallic one having excellent degassing and corrosion-resistant characteristics, so that it is possible to feed a ultra-high purity gas containing impurities extremely little.

In this invention, no organic material is used in a gas feed system, so that a quantity of gasses released from a surface of the gas-contacting section is reduced and a ultra-high vacuum and extremely clean depressurizing system as well as a gas feed system having excellent corrosion resistance against reactive and corrosive gasses can be obtained.

Brief Description of the Drawings

Fig. 1 is a system diagram of an embodiment 1 ( Liquified gas storage tank - Refining tank - Process system ) of a piping system including no organic material in gas-contacting sections in a process gas feed system according to this invention.

Fig. 2 is a system diagram of an embodiment 2 (Cylinder cabinet - Process system ) of a piping system including no organic material in gas-contacting sections in a process gas feed system according to this invention.

Fig. 3 is a graph showing difference in gas release characteristics under the room temperature between a valve having organic materials in the gas-contacting sections and a valve having no organic materials in the gas-contacting sections.

Fig. 4 is a graph showing difference in gas release characteristics under a high temperature (130 °C) between a valve having organic materials in the gas-contacting sections and a valve having no organic material in the gas-contacting section.

Fig. 5 is a graph showing representative spectrums under a high temperature.

Fig. 6 is a drawing illustrating how to see data provided by an APIMS (Atmospheric pressure ion mass spectrometer), which is a graph simply showing behaviors of host gas (Argon) ions and water ions associated with change of the moisture quantity.

Fig. 7 is a cross section of an example of a valve.

101 is a liquified gas storage tank, 102 is a gas refining system, 103 is a valve port, 104 is a control unit, 105 is a processing system, 106,107,108,109,110,111 and 112 are stop valves, 113,114,115,116,117,118,119,120,121 and 122 are process gas feed pipes, 123 is a gas discharge line, 201,202 and 203 are processing systems, 204,205 and 206 are control units, 207 is a cylinder cabinet piping system, 208,209,210,211,212,213,214,215,216,217,218,219,-220 and 221 are stop valves, 222,222' and 222'' are process gas feed lines, 223 is a purge gas feed line, and 224 and 225 are purge gas discharge lines.

Optimal Form for Implementation of This Invention

( Embodiment 1 )

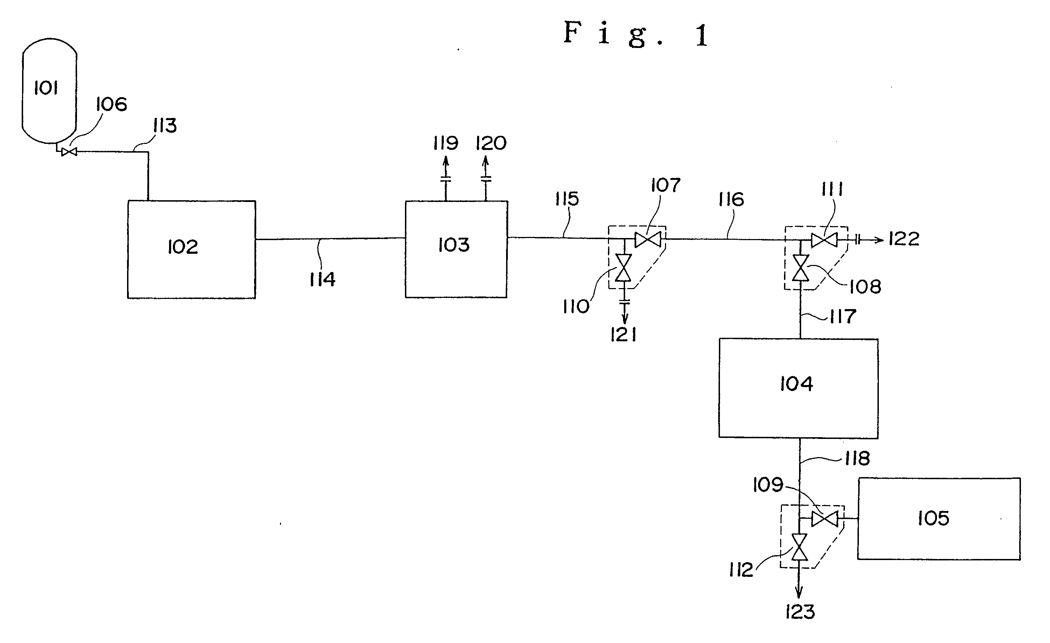

Fig.1 is a schematic drawing of an example of piping system in an embodiment of a gas feed system according to this invention.

101 is a system comprising a liquified gas storage tank and an carburetor, which stores liquified gas produced by a liquified gas producing system such as nitrogen gas, oxygen gas, and argon gas, and sends the gas to a processing system or other systems. In this liquified gas storage tank, electrolytic polishing was applied to the inner surface to eliminate generation of particles and minimize release of gasses. Of course, 101 may be a liquified gas producing system (on-site plant).

102 is a gas refining system, which refines gas fed from 101 and feeds high purity gas to the processing system. Of course, equipment constituting this system may vary according to a type of gas to be fed, and generally there are may valves and filters at an exit of a refining system. It is needless to say that the components do not include any organic material in their gas-contacting sections, and any organic material is not included in gas-contacting sections of piping components before the above components, neither;

103 is a valve port, which feeds ultra-high purity gas fed from the refining system 102 to multiple units of processing system. Although Fig. 1 shows a one gas feed line branched to 3 lines, generally a feed line comprises 3 to 5 lines, while a branch line comprises 2 to 4 lines, so that multiple types of gas can be fed to the processing systems.

104 is a control unit which regulates pressure and flow rate of gas to be fed to a processing system, and generally comprises a mass flow controller, a filter, valves, and a regulator.

107,108,109,110,111 and 112 are stop valves, 107 and 110, 108 and 111, and 109 and 112 are two-throw three-directional valves wherein 2 valves are integrated respectively, and each of the two-throw three-directional valves branches the gas feed piping system. Electrolytic polishing is applied to inner surfaces of these component to eliminate leakage to outside and minimize release of gasses, and no organic material is included in the gas-contacting sections.

113,114,115,116,117 and 118 are piping linking each system, and generally stainless steel pipes with the thickness from 1/4" to 1/2" are used. In this case, SUS 316 L pipe with inner surface electrolytically polished is used to eliminate particles and minimize release of gasses. 105 is a process chamber, and 106 is a stop valve. 119 and 120 branch lines from the valve port 103, 121 and 122 are branch lines from the pipes 115 and 116, which feed gas to each processing system.

123 is a discharge line for gas to be fed to the chamber 105, which discharge gas to outdoors by making an appropriate processing such as feeding into a discharge gas processing system according to a type of the gas.

Note that the above-described process gas feed line was completely made of metallic materials and a processing for metal passivation could be made to feed further higher purity process gas. For instance, a stainless passive state film obtained by processing for 5 to 10 hours in ultra-high purity oxygen ( with the moisture contents of around 10 ppb or less) under a temperature of 500 °C not only did not absorb moisture almost at all with a little adhesion, and the adhered moisture could easily be removed. In measurement of change in the moisture contents under the same conditions as those shown in Fig. 3, no moisture was observed in 15 minutes after the measurement was started. As described above, it is preferable to produce a passive state film by heating under a temperature from not less than 400 °C to less than 550 °C or under a temperature of not less than 550 °C for less than 9 hours, and preferably by heating under a temperature of not less than 550 °C for less than 9 hours, but also in case of a passive state film formed in ultra-high purity oxygen ( with the impunities content of less than 1 ppb) under a temperature from 200 to 250 °C, good results were obtained.

A passive state film obtained through this type of passivation is an amorphous film such as $Fe_2O_3$ or $Cr_2O_3$, and is defined as a ceramic material in abroad sense in this invention.

(Embodiment 2)

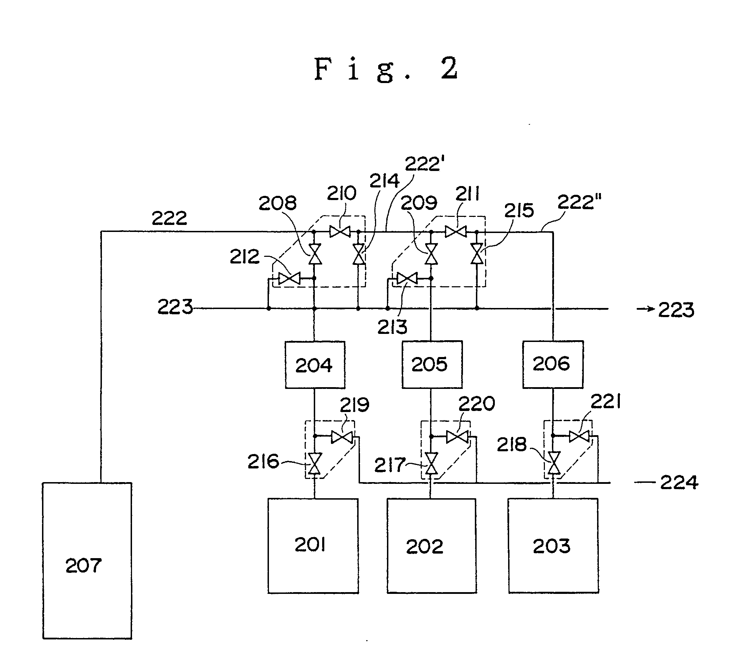

Fig.2 is a piping diagram for a gas feed system in the other embodiment of this invention, showing an example of piping for feeding gas stored in a cylinder to a cylinder cabinet to a processing system.

In this example 3 units of processing system are units, but only on process gas feed line is drawing in the figure to simplify the illustration.201, 202 and 203 are processing systems. 204, 205 and 206 are control units which regulate pressure for feeding gasses and their flow rates, which are the equivalent to 104 in Fig.1. 207 is a cylinder cabinet piping system to stores a process gas cylinder and feeds process gas. 208,209,210,211,212,213,214,215,216,217,218,219,-220 and 221 are stop valves. Of these, 208 and 210,212 and 214, 209 and 211, and 213 and 215 are mono-block valves, in each of which 4 pieces of valves are integrated respectively to minimize the gas resident section. Also, 216 and 219,217 and 220, and 218 and 221 are two-throw three-directional valves, in each of which 2 pieces of valves are integrated. All components used in these 204,205,206,207,208,209,210,211,212,213,214,215,-216,218,219, 220 and 221 are mode of materials not containing any organic material in their gas-contacting sections. 222,222' and 222'' are process gas feed pipe lines, 223 is a feed line for purge gas such as argon, 224 and 225 are purge gas discharge lines, and each of these lines generally comprises SUS 316 L pipes with the inner surfaces electrolytically polished having a thickness of 1/4" to 3/8". Note that, as all of the above-described process gas feed lines can be made of metallic materials, the metallic materials can be passivated, thus further higher purity process gas being fed.

Description was made above for gas feed systems as embodiments of this invention with reference to Fig. 1 (Liquified gas storage tank - Gas refining system - Processing system ) and Fig. 2 (Cylinder cabinet piping system - processing system). Of course, this invention can be applied to process gas feed lines in systems wherein types of gasses to be fed to processing systems,number of process gasses to be handled, and process gas feeding methods are different.

Availability for Industrial Purpose

As described above, with this invention, it is possible to assemble a gas feed piping system not including any organic material in the gas-contacting sections, and influence by released gasses centering on moisture from organic materials is eliminated, so that ultra-high purity process gas can be fed to processing systems, keeping the purity. Furthermore, passivation of metallic materials can be made by making the entire gas feed system with metallic materials to obtain excellent gas release characteristics and corrosion resistance, so that a time required for purging the piping is shortened and a high purity process gas can be fed to a processing system within a shorter time. For instance, in a gas feed piping system with the inner surface oxidized for passivation to form a passive state film thereon, a moisture content of 10 ppb or less of the use point was realized in $N_2$ purge gas within 1 day after completion of the processing.

Thus, with a system having a clean gas feed system according to this invention, it is possible to produce high quality films and carry out high quality etching.

**Claims**

1. A process gas feeder which feeds a process gas to a processing system, characterized in that gas-contacting sections of all gas feed components constituting the aforesaid gas feeder are made of materials not including any organic system to prevent inside of the gas feed piping system from being contaminated by gasses released from the organic materials.

2. The process gas feeder of Claim 1, wherein the aforesaid materials not including any organic material are metallic and or ceramic ones.

3. The process gas feeder of Claim 2, wherein the aforesaid metal or ceramics is stainless steel with a passive state film formed on the surface.

4. The process gas feeder of Claim 3, wherein the aforesaid passive state film comprises 2 or more layers including a layer formed close to an interface between the stainless steel and the passive state film and made of mainly chrome oxide and a layer formed close to a surface of the passive state film and made of mainly iron oxide.

5. The process gas feeder of Claim 4, wherein the aforesaid passive state film is formed by heating and oxidizing stainless steel under a temperature from not less than 400 °C to less than 550 °C and has a thickness of 110Å or more.

6. The process gas feeder of Claim 3, wherein the aforesaid passive state film consists of a layer made of mainly mixture of chrome oxide and iron oxide.

7. The process gas feeder of Claim 6, wherein the aforesaid passive state film is formed by heating and oxidizing stainless steel for less than 9 hours under a temperature of 550 °C or more and has a thickness of 100Å or more.

8. The process gas feeder of Claim 3, wherein the aforesaid passive state film consists of a layer made of mainly chrome oxide.

9. The process gas feeder of Claim 8, wherein the aforesaid passive state film is formed by heating and oxidizing stainless steel for 9 hours or more under a temperature of 550 °C or more and has a thickness of 130Å or more.

10. The process gas feeder of any of Claims 1 through 9, characterized in that in the surface of stainless steel on which the aforesaid passive state film is formed, the maximum difference in height between a convex section and a concave section within a circle having a radius of 5 μm or less.

11. The process gas feeder of any of Claims 4 through 10, characterized in that the aforesaid passive state film is formed in oxygen atmosphere with a moisture content of 10 ppb or below.

12. The process gas feeder of Claim 11, characterized in that a moisture content of the aforesaid oxygen atmosphere is 1 ppb or less.

13. The process gas feeder of any of Claims 1 through 12, characterized in that, in the aforesaid process gas feeder, process gas is fed from a liquified gas storage tank or a gas manufacturing system to a processing system.

14. The process gas feeder of any of Claims 1 through 13, characterized in that, in the aforesaid process gas feeder, a gas refining system is arranged and the process gas is fed via the aforesaid gas refining system to the aforesaid processing system.

15. The process gas feeder of any of Claims 1 through 14, characterized in that, in the aforesaid process gas feeder, a gas cylinder is used and the process gas is fed via a cylinder chamber piping system to the aforesaid processing system.

# Fig. 1

# Fig. 2

# F i g . 3 (A)

# F i g . 3 (B)

# F i g . 3(C)

# F i g . 3(D)

# F i g . 4(A)

# F i g . 4(B)

# Ｆｉｇ．４(C)

# Ｆｉｇ．４(D)

# Fig. 5(A)

# Fig. 5(B)

# Fig. 5(C)

# Fig. 5(D)

Fig. 6

ION INTENSITY

MOISTURE DENSITY

M/Z=40(Ar⁺)

M/Z=18(H₂O⁺)

M/Z=41(Ar·H⁺)

M/Z=19(H₂O)·H⁺

M/Z=37(H₂O)₂·H⁺

500ppb

EP 0 452 493 A1

# Fig. 7

(a)

METAL DIAPHRAGM

SPRING

SEAT VALVE

STEM

METAL DIAPHRAGM

SEAT VALVE

(b)

SPRING

STEM

EP 0 452 493 A1

# INTERNATIONAL SEARCH REPORT

International Application No  PCT/JP89/01308

## I. CLASSIFICATION OF SUBJECT MATTER (if several classification symbols apply, indicate all) °

According to International Patent Classification (IPC) or to both National Classification and IPC

Int. Cl⁵    C23C16/44, 14/22, C23F4/00,
            H01L21/302, 21/205, 21/31

## II. FIELDS SEARCHED

| Minimum Documentation Searched ⁷ | |
|---|---|
| Classification System ₁ | Classification Symbols |
| IPC | C23C16/44, 14/22, C23F4/00, H01L21/302, 21/205, 21/31 |

Documentation Searched other than Minimum Documentation
to the Extent that such Documents are Included in the Fields Searched ⁸

Jitsuyo Shinan Koho              1930 - 1990
Kokai Jitsuyo Shinan Koho        1971 - 1990

## III. DOCUMENTS CONSIDERED TO BE RELEVANT ⁹

| Category * | Citation of Document, ¹¹ with indication, where appropriate, of the relevant passages ¹² | Relevant to Claim No. ¹³ |
|---|---|---|
| X | JP, A, 62-33769 (Sumitomo Electric Industries, Ltd.), 13 February 1987 (13. 02. 87), Page 2, upper right column, line 9 to lower left column, line 8 & US, A, 4,711,547 | 1-4, 13 |
| X | JP, A, 57-160930 (National Research Development Corporation), 4 October 1982 (04. 10. 82), Page 8, upper left column, line 17 to lower left column, line 9 & EP, A1, 58571 | 1, 2, 13, 15 |
| X | JP, A, 51-67993 (Sharp Corporation), 12 June 1976 (12. 06. 76), Page 2, upper left column, line 11 to lower left column, line 2 (Family: none) | 1, 13 |
| A | JP, A, 60-238136 (Kogyo Gijutsuin-cho), 27 November 1985 (27. 11. 85), Drawing, (Family: none) | 1 - 15 |

* Special categories of cited documents: ¹⁰

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

## IV. CERTIFICATION

| Date of the Actual Completion of the International Search | Date of Mailing of this International Search Report |
|---|---|
| March 15, 1990 (15. 03. 90) | April 2, 1990 (02. 04. 90) |
| International Searching Authority | Signature of Authorized Officer |
| Japanese Patent Office | |

Form PCT ISA/210 (second sheet) (January 1985)